# EUROPEAN PATENT SPECIFICATION

(11) **EP 4 557 289 B1**
(45) Date of publication and mention of the grant of the patent: **04.02.2026**
(21) Application number: 24193048.6
(22) Date of filing: 06.08.2024
(51) Int. Cl.: G11C 11/16, H10N 50/10, H10N 50/85

(54) **MAGNETIC TUNNEL JUNCTION ELEMENT AND MEMORY DEVICE INCLUDING MAGNETIC TUNNEL JUNCTION ELEMENT**
MAGNETISCHES TUNNELELEMENT UND SPEICHERVORRICHTUNG MIT MAGNETISCHEM TUNNELELEMENT
ÉLÉMENT DE JONCTION TUNNEL MAGNÉTIQUE ET DISPOSITIF DE MÉMOIRE COMPRENANT UN ÉLÉMENT DE JONCTION TUNNEL MAGNÉTIQUE

(30) Priority: 20.11.2023 KR 20230161053
(43) Date of publication of application: 21.05.2025
(73) Proprietor: SAMSUNG ELECTRONICS CO., LTD., Yeongtong-gu, Suwon-si, Gyeonggi-do 16677 (KR)
(72) Inventor: KIM, Ki Woong, 16677 Suwon-si, Gyeonggi-do (KR); RYU, Jeongchun, 16677 Suwon-si, Gyeonggi-do (KR); KIM, Kwang Seok, 16677 Suwon-si, Gyeonggi-do (KR); PARK, Seonggeon, 16677 Suwon-si, Gyeonggi-do (KR); LEE, Seungjae, 16677 Suwon-si, Gyeonggi-do (KR)
(74) Representative: Kuhnen & Wacker Patent- und Rechtsanwaltsbüro PartG mbB

(56) References cited:
- US-A1- 2014 264 671
- US-A1- 2018 026 182

## Description

### (a) Technical Field

The present disclosure relates to a magnetic tunnel junction element and a memory device including a magnetic tunnel junction element.

### (b) Description of the Related Art

Magnetic random access memory (MRAM) devices utilize magnetic tunnel junction elements to store data by using changes in the element's resistance. The resistance of a magnetic tunnel junction element changes based on the magnetization direction of a free layer. For example, if the magnetization direction of the free layer is the same as that of a pinned layer, the magnetic tunnel junction element has a low resistance. Conversely, if the magnetization direction of the free layer is opposite to that of the pinned layer, the magnetic tunnel junction element has a high resistance. This principle enables MRAM devices to represent binary data, for example, a low resistance state indicates data '0', while a high resistance state indicates data '1'.

US 2018/026182 A1 discloses a magnetic device including a free layer; a pinned layer; a tunnel barrier disposed between the free layer and the pinned layer; a polarization enhancement layer disposed between the tunnel barrier and the pinned layer; and a blocking layer disposed between the polarization enhancement layer and the pinned layer, wherein the blocking layer includes a first diffusion trap layer and a second diffusion trap layer disposed on the first diffusion trap layer.

### SUMMARY

The present disclosure provides a magnetic tunnel junction element with high tunneling magnetoresistance and an exchange field, and a memory device including a magnetic tunnel junction element. Embodiments of the present disclosure are set out in the appended claims.

### BRIEF DESCRIPTION OF THE DRAWINGS

FIG. 1 is a cross-sectional view showing the schematic structure of a magnetic tunnel junction element according to an embodiment of the present disclosure.
FIG. 2 shows magnetic hysteresis curves measured while varying the materials of a buffer layer and an auxiliary layer of the magnetic tunnel junction element according to the embodiment of FIG. 1.
FIG. 3 shows the same cross-section as FIG. 1 for another embodiment of the present disclosure.
FIG. 4 shows the same cross-section as FIG. 1 for another embodiment of the present disclosure.
FIG. 5 briefly illustrates one memory cell including a magnetic tunnel junction element according to an embodiment of the present disclosure.
FIG. 6 is a circuit diagram schematically showing the configuration of a memory device including a plurality of memory cells shown in FIG. 5.

### DETAILED DESCRIPTION OF THE EMBODIMENTS

Hereinafter, embodiments of the present disclosure will be described in detail hereinafter with reference to the accompanying drawings. As those skilled in the art would realize, the described embodiments may be modified in various different ways, without departing from the scope of the present disclosure.

The drawings and description are to be regarded as illustrative in nature and not restrictive. Like reference numerals may designate like elements throughout the specification.

Size and thickness of each constituent element (e.g., layers, films, panels, regions, etc.) in the drawings are illustrated for better understanding and ease of description. Consequently, the following embodiments are not limited thereto.

It will be understood that when an element such as a layer, film, region, or substrate is referred to as being "on" another element, it can be directly on the other element or intervening elements may also be present. When an element is referred to as being "directly on" another element, there are no intervening elements present. Further, when an element is referred to as being "on" a reference element, it can be positioned above or below the reference element.

In addition, unless explicitly described to the contrary, the word "comprise", and variations such as "comprises" or "comprising", will be understood to imply the inclusion of the stated elements but not the exclusion of any other elements.

In addition, the phrase "on a plane" may mean a view from a position above the object (e.g., from the top), and the phrase "on a cross-section" may mean a view of a cross-section of the object which is vertically cut from the side.

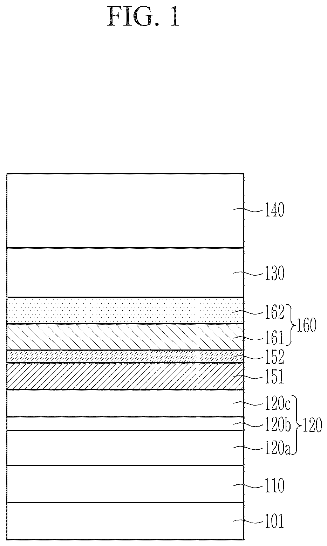

FIG. 1 is a cross-sectional view showing the schematic structure of a magnetic tunnel junction element according to an embodiment. Referring to FIG. 1, a magnetic tunnel junction element according to an embodiment may include an electrode 101, a seed layer 110 located on the electrode 101, a pinned layer 120 located on the seed layer 110, a buffer layer 151 located on the pinned layer 120, an auxiliary layer 152 located on the buffer layer 151, a polarization enhancement layer 160 located on the auxiliary layer 152, a tunnel barrier layer 130 located on a polarization enhancement layer 160, and a free layer 140 located on the tunnel barrier layer 130. Additionally, a capping metal may be further disposed on the free layer 140.

The electrode 101 may include a conductive material, enabling the electrode 101 to apply current to the magnetic tunnel junction element. The electrode 101 may include a low-resistance metal or metal nitride. For example, the electrode 101 may include TiN or TaN. The electrode 101 may be a part of the magnetic tunnel junction element; however, the electrode 101 may be a part of a memory device including a magnetic tunnel junction element.

The seed layer 110 may be located on the electrode 101. For example, the seed layer 110 may be in direct contact with the electrode 101. The seed layer 110 may include Ru, Pt, Pd, or a combination thereof. In an embodiment, an interlayer may be located between the electrode 101 and the seed layer 110. The intermediate layer may be used to match the crystal structure of the electrode 101 and the seed layer 110 in an area between the electrode 101 and the seed layer 110. For example, the interlayer may include Ta.

The pinned layer 120 and the free layer 140 may be made of a ferromagnetic metal material with magnetism. For example, the pinned layer 120 and the free layer 140 may include iron (Fe), cobalt (Co), nickel (Ni), manganese (Mn), ruthenium (Ru), Fe-containing alloy, Co-containing alloy, Ni-containing alloy, Mn-containing alloy, Ru-containing alloy, Heusler alloy, or a combination thereof. The pinned layer 120 may have a fixed magnetization direction, and the free layer 140 may have a variable magnetization direction. The magnetic tunnel junction element may have low resistance when the magnetization directions of the pinned layer 120 and the free layer 140 are the same (e.g., parallel). The magnetic tunnel junction element may have high resistance when the magnetization directions of the pinned layer 120 and the free layer 140 are opposite (e.g., antiparallel). This phenomenon is called tunneling magnetoresistance (TMR). By applying TMR, the magnetic tunnel junction element 100 may be used in a memory device.

As will be described in detail hereinafter, the magnetic tunnel junction element according to the present embodiment can mitigate the challenges of exchange field (Hex) degradation and reduced tunneling magnetoresistance (TMR). These issues often arise due to diffusion and crystalline collision among layers in the magnetic tunnel junction element.

The pinned layer 120 and the free layer 140 may have high perpendicular magnetic anisotropy (PMA), particularly interface perpendicular magnetic anisotropy (IPMA). In other words, the energy related to perpendicular magnetic anisotropy of the pinned layer 120 and the free layer 140 may exceed the energy associated with out-of-plane demagnetization. In this case, the magnetic moments of the pinned layer 120 and the free layer 140 may be stabilized in a direction perpendicular to the layer direction. The magnetic tunnel junction element may be applied to spin transfer torque-magnetic RAM (STT-MRAM) or spin-orbit coupling torque (SOT) MRAM.

To increase the operation speed of the memory device using the magnetic tunnel junction element, the free layer 140 may have a low saturation magnetization (Ms). To lower the saturation magnetization of the free layer 140, the free layer 140 may be further doped with a non-magnetic metal element. For example, the free layer 140 may be doped with a metal such as calcium (Ca), scandium (Sc), yttrium (Y), magnesium (Mg), strontium (Sr), barium (Ba), zirconium (Zr), beryllium (Be), titanium (Ti), hafnium (Hf), vanadium (V), zinc (Zn), niobium (Nb), manganese (Mn), aluminum (Al), chromium (Cr), lithium (Li), cadmium (Cd), lead (Pb), indium (In), gallium (Ga), tantalum (Ta), or a combination thereof. The non-magnetic metal doped into the free layer 140 may have an oxygen affinity higher than that of the ferromagnetic metal material of the free layer 140.

Additionally, the free layer 140 may have two or more multi-layer structures including a layer containing only a ferromagnetic metal material and a layer doped with a non-magnetic metal. Through the material and structure of the free layer 140, diffusion of oxygen or metal elements may be reduced or prevented at the interface between the tunnel barrier layer 130 and the free layer 140, which will be described later.

The tunnel barrier layer 130 provides a magnetic tunneling junction between the pinned layer 120 and the free layer 140. The tunnel barrier layer 130 may include crystalline metal oxide. For example, the tunnel barrier layer 130 may include MgO, MgAl₂O₄, MgTiOx, or a combination thereof. In an embodiment, the tunnel barrier layer 130 may include MgO.

The pinned layer 120 may be a synthetic antiferromagnet (SAF). The pinned layer 120 may include a first ferromagnetic layer 120a, a second ferromagnetic layer 120c, and a synthetic antiferromagnet (SAF) coupling layer 120b located between the first ferromagnetic layer 120a and the second ferromagnetic layer 120c. The first ferromagnetic layer 120a may be in direct contact with the seed layer 110.

The SAF coupling layer 120b may include a conductive metal. For example, the SAF coupling layer 120b may include at least one of iridium (Ir), ruthenium (Ru), aluminum (Al), copper (Cu), silver (Ag), and alloys including thereof.

Each of the first ferromagnetic layer 120a and the second ferromagnetic layer 120c may have a single-layer structure made of a ferromagnetic metal or an alloy of a ferromagnetic metal and a transition metal. In the alternative, each of the first ferromagnetic layer 120a and the second ferromagnetic layer 120c may have a multi-layer structure including a plurality of layers including a ferromagnetic metal or an alloy of a ferromagnetic metal and a transition metal. For example, each of the first ferromagnetic layer 120a and the second ferromagnetic layer 120c may include a single-layer structure or multi-layer structure including Co, Fe, CoPt, CoPtCr, FePt, CoFe, etc. In an embodiment, the first ferromagnetic layer 120a may include CoPt, and the second ferromagnetic layer 120c may include Co.

In this structure of this pinned layer 120, the first ferromagnetic layer 120a and the second ferromagnetic layer 120c may form an antiferromagnet by means of the SAF coupling layer 120b due to the Ruderman-Kittel-Kasuya-Yosida (RKKY) interaction. In other words, the pinned layer 120 may have a stable state when a magnetization direction of the first ferromagnetic layer 120a and a magnetization direction of the second ferromagnetic layer 120c are opposite to each other. For example, the first ferromagnetic layer 120a may be magnetized toward a lower surface and the second ferromagnetic layer 120c may be magnetized toward an upper surface. In the alternative, the first ferromagnetic layer 120a may be magnetized toward an upper surface and the second ferromagnetic layer 120c may be magnetized toward a lower surface. The first ferromagnetic layer 120a and the second ferromagnetic layer 120c magnetized in opposite directions (e.g., antiparallel with each other) may offset stray magnetic fields from each other. Therefore, the first ferromagnetic layer 120a and the second ferromagnetic layer 120c that are magnetized in opposite directions, reduce or prevent the stray magnetic field generated in the pinned layer 120 from affecting the free layer 140.

Referring to FIG. 1, the buffer layer 151 may be located on the second ferromagnetic layer 120c. The buffer layer 151 may be in direct contact with the second ferromagnetic layer 120c. The buffer layer 151 is amorphous, and may alleviate crystalline collisions between the lower layer and the upper layer.

The buffer layer 151 may include CoFeBX. In this case, X may be W, Mo, Re, or Ta. The thickness of the buffer layer 151 may be 0.1 to 0.4 nm. If the thickness of the buffer layer 151 is less than 0.1 nm, it may not sufficiently alleviate crystalline collisions, and if the thickness is more than 0.4 nm, it may cause decoupling. Since the buffer layer 151 is amorphous, the buffer layer 151 may alleviate crystalline collisions caused by the difference in crystal structure between the second ferromagnetic layer 120c located on a lower portion and the polarization enhancement layer 160 located on an upper portion. Specific effects will be described separately later.

The auxiliary layer 152 may be located on the buffer layer 151. The auxiliary layer 152 may include W, Mo, or Ta. This auxiliary layer 152 includes a material with high-temperature heat resistance, which may prevent the diffusion of cobalt and boron in the magnetic tunnel junction element. The following Table 1 shows the structures and melting points of various materials.

**[Table 1]**

| Material | Co | W | Mo | Ta |
|---|---|---|---|---|
| Structure | HCP | BCC | BCC | BCC |
| Melting point | 1495°C | 3422°C | 2623°C | 3017°C |

Referring to the Table 1, W, Mo, and Ta included in the auxiliary layer 152 have a higher melting point than Co. Therefore, when the auxiliary layer 152 containing such materials is placed between the second ferromagnetic layer 120c and the polarization enhancement layer 160, diffusion of cobalt and boron may be prevented.

However, as can be seen in Table 1 above, the crystal structures of Co, W, Mo, and Ta are different. In other words, Co has a hexagonal close packing (HCP), and W, Mo, and Ta have a body centered cubic (BCC) structure. Therefore, if W, Mo, or Ta is formed right above the Co layer, crystalline collisions may occur at the interface. However, in the magnetic tunnel junction element according to the embodiment, the amorphous buffer layer 151 is located between the second ferromagnetic layer 120c containing Co and the auxiliary layer 152 containing W, Mo, or Ta, so that crystalline collisions may be prevented.

The thickness of the auxiliary layer 152 may be 0.05 to 0.2 nm. The process of forming the auxiliary layer 152 to a thickness of 0.05 nm or less is not easy, and if the thickness of the auxiliary layer 152 is more than 0.2nm, decoupling may occur. Although it will be described in detail later, the auxiliary layer 152 may have the same crystal structure as the polarization enhancement layer 160 to be formed later, and thus, may function as a seed layer during the formation of the polarization enhancement layer 160, thereby enhancing the crystallinity of the polarization enhancement layer 160. For example, the auxiliary layer 152 may have a body centered cubic (BCC) structure. The thickness of the auxiliary layer 152 may be thinner than the thickness of the buffer layer 151.

The polarization enhancement layer 160 may be located on the auxiliary layer 152. The polarization enhancement layer 160 may help the tunnel barrier layer 130 and the free layer 140 grow. Additionally, the polarization enhancement layer 160 has a crystal structure similar to that of the tunnel barrier layer 130 or the free layer 140. Consequently, the polarization enhancement layer 160 may further improve the crystal quality of the tunnel barrier layer 130 and the free layer 140. To achieve this, the polarization enhancement layer 160 may include a ferromagnetic material similar to the free layer 140.

The polarization enhancement layer 160 may include a first polarization enhancement layer 161 and a second polarization enhancement layer 162. The second polarization enhancement layer 162 may be located between the first polarization enhancement layer 161 and the tunnel barrier layer 130. For example, the second polarization enhancement layer 162 may be in direct contact with the first polarization enhancement layer 161 and the tunnel barrier layer 130.

The first polarization enhancement layer 161 and the second polarization enhancement layer 162 may include the same material and have different composition ratios. The first polarization enhancement layer 161 and the second polarization enhancement layer 162 may include, for example, CoFeB. The ratio of boron (B) in the second polarization enhancement layer 162 may be smaller than the ratio of boron (B) in the first polarization enhancement layer 161. For example, the ratio of boron (B) in the first polarization enhancement layer 161 may be about 30 mol% to about 50 mol%, and the ratio of boron (B) in the second polarization enhancement layer 162 may be about 5 mol% to about 25 mol%.

Additionally, the thickness of the second polarization enhancement layer 162 may be smaller than the thickness of the first polarization enhancement layer 161. For example, the thickness of first polarization enhancement layer 161 may be about 0.5 nm to about 0.7 nm, and the thickness of the second polarization enhancement layer 162 may be about 0.1 nm to about 0.3 nm. The composition ratio in the polarization enhancement layer 160 can be gradually adjusted to easily change the crystal structure from the pinned layer 120 to the free layer 140. Accordingly, the crystal quality of the tunnel barrier layer 130 and the free layer 140 may be further improved.

Alternatively, the first polarization enhancement layer 161 and the second polarization enhancement layer 162 may have different compositions. Specifically, the first polarization enhancement layer 161 may include cobalt, and the second polarization enhancement layer 162 may not include cobalt. For example, the first polarization enhancement layer 161 may include CoFeB, and the second polarization enhancement layer 162 may include FeB.

The second polarization enhancement layer 162 is located adjacent to the tunnel barrier layer 130. For example, the second polarization enhancement layer 162 may be in direct contact with the tunnel barrier layer 130. The performance of the magnetic tunnel junction element may be improved when the second polarization enhancement layer 162 adjacent to the tunnel barrier layer 130 does not contain cobalt. For example, in the heat treatment process, cobalt may diffuse in both the pinned layer 120 direction and the free layer 140 direction. Therefore, cobalt may diffuse toward the tunnel barrier layer 130, which may affect the performance of the magnetic tunnel junction element. However, when the second polarization enhancement layer 162 does not contain cobalt, the diffusion of cobalt toward the tunnel barrier layer 130 may be reduced.

In the magnetic tunnel junction element according to the embodiment, the first ferromagnetic layer 120a configures a lower pinned layer with the SAF coupling layer 120b positioned in between. Meanwhile, the second ferromagnetic layer 120c, the buffer layer 151, the auxiliary layer 152 and the polarization enhancement layer 160 configure an upper pinned layer. The first ferromagnetic layer 120a, which is the lower pinned layer, may include CoPt. Additionally, the upper pinned layer may use Co as the second ferromagnetic layer 120c and CoFeB as the polarization enhancement layer 160. The Co/CoFeB combinations should have high tunneling magnetoresistance (TMR) values.

However, since Co is an HCP structure and CoFeB is a BCC structure, crystalline collisions occur when CoFeB is formed right above Co. In addition, there diffusion occurs at the interface between Co and CoFeB during the high-temperature heat treatment process for manufacturing a magnetic tunnel junction element, thereby reducing tunneling magnetoresistance characteristics of the magnetic tunnel junction element. In other words, diffusion changes the crystallinity of Co and CoFeB, which may lead to a decrease in exchange field (Hex).

Accordingly, the magnetic tunnel junction element according to the embodiment is designed to maintain the inherent crystallinity of each material even under high-temperature heat treatment by positioning an amorphous buffer layer 151 containing CoFeBX (X = W, Mo, Re or Ta) between the second ferromagnetic layer 120c containing Co and the polarization enhancement layer 160 containing CoFeB. In other words, the magnetic tunnel junction element, as described in the embodiment, can preserve the intrinsic crystallinity of each material, even when subjected to high-temperature heat treatment. This is achieved by incorporating the amorphous buffer layer 151 containing CoFeBX between the second ferromagnetic layer 120c containing Co and the polarization enhancement layer 160 containing CoFeB.

The buffer layer 151 is amorphous, which may alleviate the crystalline collision between the HCP structure of Co and the BCC structure of CoFeB. In other words, if the BCC structure is formed directly above the HCP structure, crystalline collisions may occur at the interface due to the difference in crystal structure. However, as in the present embodiment, if an amorphous buffer layer is located between the HCP and BCC, such crystalline collisions may be prevented.

Additionally, in the present embodiment, the auxiliary layer 152 may be located on the buffer layer 151. The auxiliary layer 152 may include W, Mo, or Ta. The auxiliary layer 152 has a BCC structure, and may be used as a seed layer for the growth of CoFeB with a BCC structure. Therefore, the crystallinity of CoFeB formed on the auxiliary layer 152 may be strengthened. Additionally, the auxiliary layer 152 includes a material with high-temperature resistance, and thus, may prevent the diffusion of elements between the second ferromagnetic layer 120c and the polarization enhancement layer 160.

Additionally, in the magnetic tunnel junction device according to this embodiment, the buffer layer 151 and the auxiliary layer 152 are located between Co and CoFeB. Therefore, the entire thickness of the Co and CoFeB junction increases, and the Ms value may be reduced due to the increase in thickness. This may increase the exchange field.

In this case, the thickness of the buffer layer 151 may be thicker than the thickness of the auxiliary layer 152. The thickness of the buffer layer 151 may be 0.1 nm to 0.4 nm, and the thickness of the auxiliary layer 152 may be 0.05 nm to 0.2 nm. If the thickness of the buffer layer 151 is less than 0.1 nm, it may not have a sufficient crystal mismatch alleviation effect. Additionally, when the thickness of the buffer layer 151 exceeds 0.4 nm or the thickness of the auxiliary layer 152 becomes thicker than 0.2 nm, decoupling may occur between Co and CoFeB, which is not desirable. In other words, the sum of the thicknesses of the buffer layer 151 and the auxiliary layer 152 located between the layer containing Co and the layer containing CoFeB should not exceed 0.5 nm. When the sum of the thicknesses of the buffer layer 151 and the auxiliary layer 152 exceeds 0.5 nm, decoupling between Co and CoFeB may occur.

The effects of the magnetic tunnel junction element according to the present embodiment will be described below through specific experimental examples.

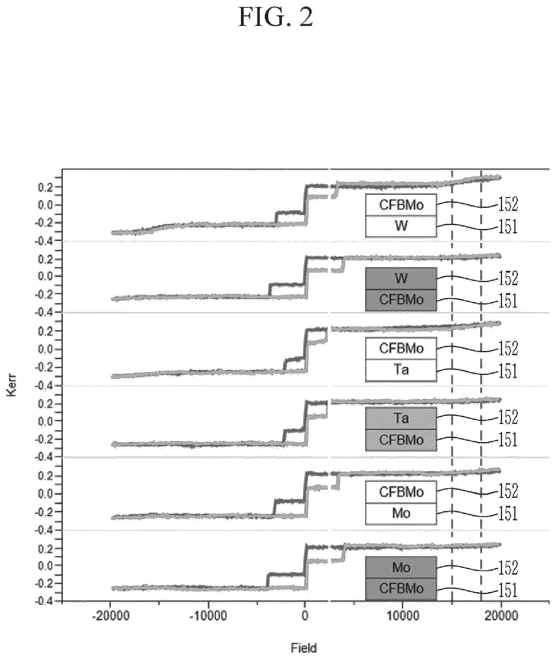

FIG. 2 shows magnetic hysteresis curves measured while varying the materials of the buffer layer 151 and the auxiliary layer 152 of the magnetic tunnel junction element according to the embodiment.

In addition, Table 2 shows the resistance per unit area (RA, Ω*µ*m²) and tunneling magnetoresistance (TMR) of the materials of the buffer layer 151 and the auxiliary layer 152 tested in FIG. 2. Experimental Examples 1 and 2 change the order of the auxiliary layer/buffer layer for the same material, and show the improvement ratio of Experimental Example 2 when the efficiency of Experimental Example 1 is set to 100. In the case of Experimental Examples 3 and 4, the improvement ratio of Experiment 4 is shown when the efficiency of Experiment 3 is set to 100, by changing the order of the auxiliary layer/buffer layer for the same material. In the case of Experiment 5 and Experiment 6, the improvement ratio of Experiment 6 is shown when the efficiency of Experiment 5 is set to 100, by changing the order of the auxiliary/buffer layers for the same material. In Table 2 below, Experimental Examples 2, 4, and 6 are included in the embodiments of the present disclosure.

**[Table 2]**

| | Experimental Example 1 | Experimental Example 2 | Experimental Example 3 | Experimental Example 4 | Experimental Example 5 | Experimental Example 6 |
|---|---|---|---|---|---|---|
| Auxiliary layer | CoFeBMo | W | CoFeBMo | Ta | CoFeBMo | Mo |
| Buffer layer | W | CoFeBMo | Ta | CoFeBMo | Mo | CoFeBMo |
| RA | 7.5 | 8.9 | 7.3 | 7.7 | 9.5 | 9.9 |
| TMR | 187.2 | 188.7 | 127.4 | 161.3 | 184.7 | 180.6 |
| TMR improvement ratio | 100 | 100.8 | 100 | 126.6 | 100 | 97 |

First, referring to FIG. 2, in the case of Experimental Example 1 (auxiliary layer CFBMo/buffer layer W) combination, the inflection point in the magnetic hysteresis curve appeared near about 18 kOe. The part where this inflection point appears corresponds to the exchange field (Hex) value of the magnetic tunnel junction element. However, in the case of Experimental Examples 2, 4, and 6 included in the embodiment of the present disclosure, the inflection point of the magnetic tunnel junction element did not appear in FIG. 2, and it can be seen that the exchange field (Hex) value was 18 kOe or more.

In addition, referring to Table 2, it can be seen that Experimental Example 2 included in the embodiment of the present disclosure has a higher tunneling magnetoresistance (TMR) value than Experimental Example 1, and Experimental Example 4 has a higher tunneling magnetoresistance (TMR) value than Experimental Example 3.

In other words, it can be seen that the magnetic tunnel junction element including a buffer layer and an auxiliary layer as in the present embodiment had a high exchange field (Hex) and a high tunneling magnetoresistance (TMR). This is due to the buffer layer mitigating the crystalline collision between cobalt and CoFeB, as previously discussed. In addition, the auxiliary layer acts to prevent the diffusion of cobalt and boron, serving as a seed layer on which CoFeB of the BCC structure may grow. In Table 3 and FIG. 2 above, it was confirmed that the combination of the buffer layer CFBMo and the auxiliary layer W of Experimental Example 2 was the most effective. While using different materials of the polarization enhancement layer 160 for this combination of the buffer layer CFBMo and the auxiliary layer W, the resistance per unit area (RA, Ω*µ*m2) and the tunneling magnetoresistance TMR were measured and shown in Table 3.

**[Table 3]**

| | | | Experimental Example 7 | Experimental Example 8 | Experimental Example 9 | Experimental Example 10 |
|---|---|---|---|---|---|---|
| Polarization enhancement layer | | Second polarization enhancement layer | FeB20 (single layer) | FeB20 | CoFeB20 | CoFe |
| | | First polarization enhancement layer | | CoFeB30 | FeB20 | FeB20 |
| | RA | | 6.1 | 6 | 6.5 | 6.5 |
| | TMR | | 190.4 | 205.1 | 191.8 | 181.6 |

In Table 3, the number next to B indicates the boron content. In other words, CoFeB30 contains 30 mol% of Boron, and FeB20 contains 20 mol% of Boron.

Experimental Example 7 was conducted using a single layer polarization enhancement layer. Experimental Example 8 was conducted with a lower boron content in the second polarization enhancement layer than in the first polarization enhancement layer, and with the second polarization enhancement layer not containing cobalt.

Experimental Example 9 was conducted in which the boron concentration in the first polarization enhancement layer and the second polarization enhancement layer was the same, and the first polarization enhancement layer did not contain cobalt. Experimental Example 10 was conducted in which the first polarization enhancement layer did not contain cobalt and the second polarization enhancement layer did not contain boron.

Referring to Table 3, it can be seen that Experimental Example 8, which corresponds to the present embodiment, had the highest tunneling magnetoresistance (TMR) value.

In other words, if the first polarization enhancement layer 161 includes CoFeB, and the second polarization enhancement layer 162 includes FeB and does not include cobalt, it is possible to reduce the diffusion of cobalt towards the tunnel barrier layer 130, thereby improving the tunneling magnetoresistance (TMR).

The magnetic tunnel junction element according to the present embodiment has the buffer layer 151 and the auxiliary layer 152 located between the second ferromagnetic layer 120c and the polarization enhancement layer 160, for example, between Co and CoFeB in the stack structure of the magnetic tunnel junction element.

The buffer layer 151 alleviates the crystalline collision between the HCP structure of cobalt and the BCC structure of CoFeB, and the auxiliary layer 152 with a BCC structure acts as a seed layer for the growth of CoFeB, thereby strengthening the crystallinity of the CoFeB layer. Additionally, the auxiliary layer 152 may prevent the diffusion of cobalt and boron during a high-temperature process of 400°C or higher. In addition, the polarization enhancement layer 160 has a multi-layer structure, and the boron concentration of the upper layer is lower than the boron concentration of the lower layer, thereby reducing the diffusion of boron into the tunnel barrier layer. Depending on the embodiment, when the polarization enhancement layer 160 has a multi-layer structure, the upper layer may not contain cobalt. In this case, the diffusion of cobalt toward the tunnel barrier layer 130 may be reduced, thereby improving tunneling magnetoresistance (TMR).

Hereinafter, other embodiments of the present disclosure will be described. In the magnetic tunnel junction element according to the present embodiment, heat treatment of the auxiliary layer 152 may be performed after forming the auxiliary layer 152. In other words, after forming the auxiliary layer 152, the crystallinity of the auxiliary layer 152 may be strengthened by heat treating the auxiliary layer 152. When the crystallinity of the auxiliary layer 152 is strengthened by the heat treatment of the auxiliary layer 152, the crystallinity of the polarization enhancement layer 160 formed thereafter may also be improved. This is because when the crystallinity of the auxiliary layer 152, which is a seed layer, is improved, the crystallinity of the polarization enhancement layer 160 formed thereon is also improved.

In FIG. 1, a configuration including the buffer layer 151, the auxiliary layer 152, the first polarization enhancement layer 161, and the second polarization enhancement layer 162 was shown, but in other embodiments, only some of the layers may be included.

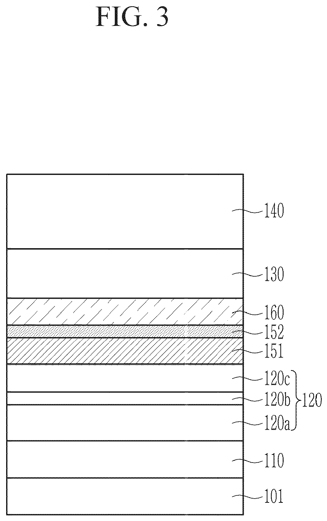

FIG. 3 shows the same cross-section as Fig. 1 for another embodiment. Referring to FIG. 3, the display device according to the present embodiment is the same as the embodiment of FIG. 1 except that the polarization enhancement layer 160 is a single layer. For example, in the embodiment of FIG. 3, the polarization enhancement layer 160 may be made of a single layer. For example, the polarization enhancement layer 160 may be a single layer containing CoFeB. Descriptions of other layers in FIG. 3 are the same as in FIG. 1 and are therefore omitted.

In this case, like that in the embodiment of FIG. 1, the crystalline collision between the HCP structure of Co and the BCC structure of CoFeB is alleviated by the buffer layer 151, and the auxiliary layer 152 having a BCC enhances the crystallinity of CoFeB by acting as a seed layer for the growth of CoFeB. The diffusion of cobalt and boron is prevented by the auxiliary layer 152, which may improve the tunneling magnetoresistance (TMR) and exchange field (Hex).

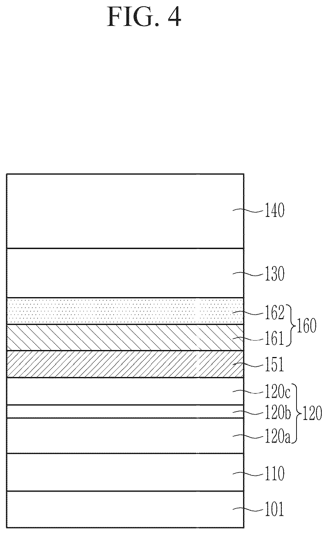

FIG. 4 shows the same cross-section as Fig. 1 for another embodiment. Referring to FIG. 4, the display device according to the present embodiment is the same as the embodiment of FIG. 1 except that it does not include the auxiliary layer 152.

Detailed descriptions of the same components are omitted. As shown in FIG. 4, even when the auxiliary layer 152 is not included, the crystalline collision between the HCP structure of cobalt and the BCC structure of CoFeB is alleviated by the buffer layer 151, thereby improving the tunneling magnetoresistance (TMR) and exchange field (Hex).

Hereinafter, a memory cell and a memory device including a magnetic tunnel junction element according to the present embodiment will be described with reference to the drawings. However, this description is only an example, and the present disclosure is not limited thereto.

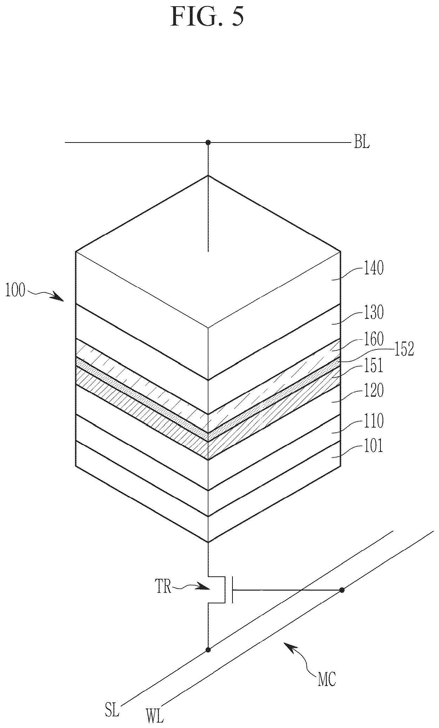

FIG. 5 briefly illustrates one memory cell including a magnetic tunnel junction element according to an embodiment. Referring to FIG. 5, a memory cell MC may include the above-described magnetic tunnel junction element 100 and a switching element (TR) connected thereto. The switching element TR may be a transistor such as a thin film transistor, for example, a field effect transistor. The memory cell MC may be connected between a bit line BL and a word line WL. The bit line BL and the word line WL may intersect each other, and the memory cell MC may be disposed at their intersection point. The bit line BL may be electrically connected to the free layer 140 of the magnetic tunnel junction element 100, and the word line WL may be connected to the gate of the switching element TR. Additionally, the first source/drain electrode of the switching element TR may be electrically connected to the electrode 101 of the magnetic tunnel junction element 100, and the second source/drain electrode of the switching element TR may be electrically connected to a selection line SL. For example, the selection line SL may extend parallel to the word line WL. In this structure, write current, read current, erase current, etc. may be applied to the memory cell MC through the word line WL and the bit line BL. In FIG. 5, the memory cell MC is shown as including the magnetic tunnel junction element 100 shown in FIG. 1, but the memory cell MC may also include magnetic tunnel junction elements according to other embodiments, such as those shown in FIGS. 3 and 4.

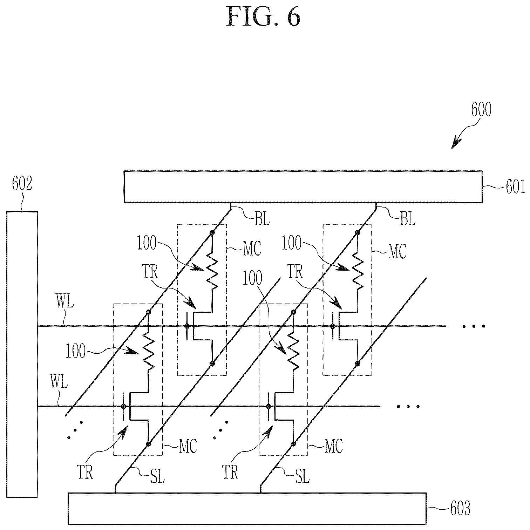

FIG. 6 is a circuit diagram schematically showing the configuration of a memory device including a plurality of memory cells shown in FIG. 5. Referring to FIG. 6, a memory device 600 may include a plurality of bit lines BL, a plurality of word lines WL, a plurality of selection lines SL, a plurality of memory cells MC disposed at each of the intersections of the plurality of bit lines BL and the plurality of word lines WL, a bit line driver 601 for applying current to the plurality of bit lines BL, a word line driver 602 for applying current to the plurality of word lines WL, and a selection line driver 603 for applying current to the plurality of selection lines SL. Each memory cell MC may have the configuration shown in FIG. 6. The memory cells MC of memory device 600 shown in FIG. 6 may be, for example, a 1T1MTJ element including one transistor and one magnetic tunnel junction element, respectively.

The memory device 600 shown in FIG. 6 may be a magnetic random access memory (MRAM) and may be used in electronic devices that use nonvolatile memory. For example, the memory device 600 shown in FIG. 6 may be an STT-MRAM, where the magnetization direction of the free layer is altered by a spin current directly applied to the free layer of the magnetic tunnel junction element. Since STT-MRAM does not require a separate conductor to generate an external magnetic field, it is useful for high integration and has a simple operation method. Additionally, the memory device 600 shown in FIG. 6 may also be applied to SOT-MRAM.

As described above, the magnetic tunnel junction element according to the present embodiment and the memory device including the same include the buffer layer 151 and the auxiliary layer 152. Thus, by employing the buffer layer 151, it is possible to prevent crystalline collisions between the layer on the upper portion and the layer on the lower portion, prevent the diffusion of elements in the magnetic tunnel junction element through the auxiliary layer 152, and strengthen the crystallinity of the upper layer.

In addition, the polarization enhancement layer 160 is formed as a multi-layer, the boron content of the upper layer is smaller than that of the lower layer and the upper layer does not contain cobalt, thereby preventing diffusion. The magnetic tunnel junction element according to the present embodiment may have high tunneling magnetoresistance (TMR) and exchange field (Hex). be an STT-MRAM, where the magnetization direction of the free layer is altered by a spin current directly applied to the free layer of the magnetic tunnel junction element. Since STT-MRAM does not require a separate conductor to generate an external magnetic field, it is useful for high integration and has a simple operation method. Additionally, the memory device 600 shown in FIG. 6 may also be applied to SOT-MRAM.

As described above, the magnetic tunnel junction element according to the present embodiment and the memory device including the same include the buffer layer 151 and the auxiliary layer 152. Thus, by employing the buffer layer 151, it is possible to prevent crystalline collisions between the layer on the upper portion and the layer on the lower portion, prevent the diffusion of elements in the magnetic tunnel junction element through the auxiliary layer 152, and strengthen the crystallinity of the upper layer.

In addition, the polarization enhancement layer 160 is formed as a multi-layer, the boron content of the upper layer is smaller than that of the lower layer and the upper layer does not contain cobalt, thereby preventing diffusion. The magnetic tunnel junction element according to the present embodiment may have high tunneling magnetoresistance (TMR) and exchange field (Hex).

While the embodiments of the present disclosure have been described above, it is to be understood that the disclosure is not limited to the disclosed embodiments. For example, the present disclosure is intended to cover various modifications and equivalent arrangements included within the scope of the appended claims.

## Claims

1. A magnetic tunnel junction element, comprising:
a pinned layer (120) having a multi-layer structure and including Co; and a free layer (140) facing the pinned layer (120);
a buffer layer (151) on the pinned layer (120);
an auxiliary layer (152) on the buffer layer (151);
a polarization enhancement layer (160) between the auxiliary layer (152) and the free layer (140); and
a tunnel barrier layer between the polarization enhancement layer (160) and the free layer (140),
wherein the buffer layer (151) is amorphous and includes CoFeBX, and X is W, Mo, Re or Ta,
the auxiliary layer (152) includes W, Mo, or Ta,
**characterised in that** the buffer layer (151) directly contacts the pinned layer (120).

2. The magnetic tunnel junction element of claim 1, wherein:
the auxiliary layer (152) is thinner than the buffer layer (151).

3. The magnetic tunnel junction element of claim 1 or 2, wherein:
a thickness of the buffer layer (151) is 0.1 nm to 0.4 nm.

4. The magnetic tunnel junction element of any one of claims 1 to 3, wherein:
a thickness of the auxiliary layer is 0.05 nm to 0.2 nm.

5. The magnetic tunnel junction element of any one of claims 1 to 4, wherein:
the sum of a thickness of the buffer layer (151) and a thickness of the auxiliary layer (152) is less than 0.5 nm.

6. The magnetic tunnel junction element of any one of claims 1 to 5, wherein:
the polarization enhancement layer (160) comprises a first polarization enhancement layer (161) and a second polarization enhancement layer (162), and
the second polarization enhancement layer (162) is between the first polarization enhancement layer (161) and the free layer (140).

7. The magnetic tunnel junction element of claim 6, wherein:
a boron concentration included in the second polarization enhancement layer (162) is lower than a boron concentration included in the first polarization enhancement layer (161).

8. The magnetic tunnel junction element of claim 6 or 7, wherein:
the first polarization enhancement layer (161) includes CoFeB,
the second polarization enhancement layer (162) does not include Co.

9. The magnetic tunnel junction element of claim 6 or 7, wherein:
the first polarization enhancement layer (161) includes CoFeB,
the second polarization enhancement layer (162) includes Co.

10. The magnetic tunnel junction element of any one of claims 1 to 9, wherein:
the auxiliary layer (152) and the polarization enhancement layer (160) have a body centered cubic, BCC, structure.

11. The magnetic tunnel junction element of any one of claims 1 to 10, wherein:
the pinned layer (120) and the polarization enhancement layer (160) have different crystal structures.

12. A memory device, comprising:
a plurality of memory cells (MC) each including a magnetic tunnel junction element and a switching element connected to the magnetic tunnel junction element,
wherein the magnetic tunnel junction element is according to any one of claims 1 to 11.

## Patentansprüche

1. Magnettunnelübergangselement, aufweisend:
eine gepinnte Schicht (120), die eine Mehrschichtstruktur aufweist und Co-haltig ist; und
eine freie Schicht (140), die der gepinnten Schicht (120) gegenüberliegt;
eine Pufferschicht (151) auf der gepinnten Schicht (120);
eine Hilfsschicht (152) auf der Pufferschicht (151);
eine Polarisationsverstärkungsschicht (160) zwischen der Hilfsschicht (152) und der freien Schicht (140); und
eine Tunnelbarriereschicht zwischen der Polarisationsverstärkungsschicht (160) und der freien Schicht (140),
wobei die Pufferschicht (151) amorph ist und CoFeBX enthält, und wobei X W, Mo, Re oder Ta ist,
die Hilfsschicht (152) W, Mo oder Ta enthält,
**dadurch gekennzeichnet, dass** die Pufferschicht (151) mit der gepinnten Schicht (120) direkt in Kontakt steht.

2. Magnettunnelübergangselement nach Anspruch 1, wobei:
die Hilfsschicht (152) dünner ist als die Pufferschicht (151).

3. Magnettunnelübergangselement nach Anspruch 1 oder 2, wobei:
eine Dicke der Pufferschicht (151) 0,1 nm bis 0,4 nm beträgt.

4. Magnettunnelübergangselement nach einem der Ansprüche 1 bis 3, wobei:
eine Dicke der Hilfsschicht 0,05 nm bis 0,2 nm beträgt.

5. Magnettunnelübergangselement nach einem der Ansprüche 1 bis 4, wobei:
die Summe aus einer Dicke der Pufferschicht (151) und einer Dicke der Hilfsschicht (152) weniger als 0,5 nm beträgt.

6. Magnettunnelübergangselement nach einem der Ansprüche 1 bis 5, wobei:
die Polarisationsverstärkungsschicht (160) eine erste Polarisationsverstärkungsschicht (161) und eine zweite Polarisationsverstärkungsschicht (162) aufweist, und
die zweite Polarisationsverstärkungsschicht (162) zwischen der ersten Polarisationsverstärkungsschicht (161) und der freien Schicht (140) angeordnet ist.

7. Magnettunnelübergangselement nach Anspruch 6, wobei:
eine in der zweiten Polarisationsverstärkungsschicht (162) enthaltene Bor-Konzentration geringer ist als eine in der ersten Polarisationsverstärkungsschicht (161) enthaltene Bor-Konzentration.

8. Magnettunnelübergangselement nach Anspruch 6 oder 7, wobei:
die erste Polarisationsverstärkungsschicht (161) CoFeB enthält,
die zweite Polarisationsverstärkungsschicht (162) kein Co enthält.

9. Magnettunnelübergangselement nach Anspruch 6 oder 7, wobei:
die erste Polarisationsverstärkungsschicht (161) CoFeB enthält,
die zweite Polarisationsverstärkungsschicht (162) Co enthält.

10. Magnettunnelübergangselement nach einem der Ansprüche 1 bis 9, wobei:
die Hilfsschicht (152) und die Polarisationsverstärkungsschicht (160) eine kubischraumzentrierte (krz-) Struktur aufweisen.

11. Magnettunnelübergangselement nach einem der Ansprüche 1 bis 10, wobei:
die gepinnte Schicht (120) und die Polarisationsverstärkungsschicht (160) unterschiedliche Kristallstrukturen aufweisen.

12. Speichervorrichtung, aufweisend:
eine Vielzahl von Speicherzellen (MC), die jeweils ein Magnettunnelübergangselement und
ein mit dem Magnettunnelübergangselement verbundenes Schaltelement aufweisen,
wobei das Magnettunnelübergangselement nach einem der Ansprüche 1 bis 11 beschaffen ist.

## Revendications

1. Élément à jonction tunnel magnétique, comprenant :
une couche bloquée (120) ayant une structure multicouche et comprenant du Co ;
une couche libre (140) en regard de la couche bloquée (120) ;
une couche tampon (151) sur la couche bloquée (120) ;
une couche auxiliaire (152) sur la couche tampon (151) ;
une couche d'amélioration de la polarisation (160) entre la couche auxiliaire (152) et la couche libre (140) ; et
une couche barrière tunnel entre la couche d'amélioration de la polarisation (160) et la couche libre (140),
dans lequel la couche tampon (151) est amorphe et comprend du CoFeBX, et X est W, Mo, Re ou Ta,
la couche auxiliaire (152) comprend du W, du Mo ou du Ta,
**caractérisé en ce que** la couche tampon (151) est en contact direct avec la couche bloquée (120).

2. Élément à jonction tunnel magnétique selon la revendication 1, dans lequel :
la couche auxiliaire (152) est plus mince que la couche tampon (151).

3. Élément à jonction tunnel magnétique selon la revendication 1 ou 2, dans lequel :
une épaisseur de la couche tampon (151) est de 0,1 nm à 0,4 nm.

4. Élément à jonction tunnel magnétique selon l'une quelconque des revendications 1 à 3, dans lequel :
une épaisseur de la couche auxiliaire est de 0,05 nm à 0,2 nm.

5. Élément à jonction tunnel magnétique selon l'une quelconque des revendications 1 à 4, dans lequel :
la somme d'une épaisseur de la couche tampon (151) et d'une épaisseur de la couche auxiliaire (152) est inférieure à 0,5 nm.

6. Élément à jonction tunnel magnétique selon l'une quelconque des revendications 1 à 5, dans lequel :
la couche d'amélioration de la polarisation (160) comprend une première couche d'amélioration de la polarisation (161) et une deuxième couche d'amélioration de la polarisation (162), et
la deuxième couche d'amélioration de la polarisation (162) est entre la première couche d'amélioration de la polarisation (161) et la couche libre (140).

7. Élément à jonction tunnel magnétique selon la revendication 6, dans lequel :
une concentration en bore incluse dans la deuxième couche d'amélioration de la polarisation (162) est inférieure à une concentration en bore incluse dans la première couche d'amélioration de la polarisation (161).

8. Élément à jonction tunnel magnétique selon la revendication 6 ou 7, dans lequel :
la première couche d'amélioration de la polarisation (161) comprend du CoFeB,
la deuxième couche d'amélioration de la polarisation (162) ne comprend pas de Co.

9. Élément à jonction tunnel magnétique selon la revendication 6 ou 7, dans lequel :
la première couche d'amélioration de la polarisation (161) comprend du CoFeB,
la deuxième couche d'amélioration de la polarisation (162) comprend du Co.

10. Élément à jonction tunnel magnétique selon l'une quelconque des revendications 1 à 9, dans lequel :
la couche auxiliaire (152) et la couche d'amélioration de la polarisation (160) ont une structure cubique centrée, BCC.

11. Élément à jonction tunnel magnétique selon l'une quelconque des revendications 1 à 10, dans lequel :
la couche bloquée (120) et la couche d'amélioration de la polarisation (160) ont des structures cristallines différentes.

12. Dispositif mémoire, comprenant :
une pluralité de cellules mémoire (MC) comprenant chacune un élément à jonction tunnel magnétique et un élément de commutation connecté à l'élément à jonction tunnel magnétique,
dans lequel l'élément à jonction tunnel magnétique est selon l'une quelconque des revendications 1 à 11.
